# EUROPEAN PATENT APPLICATION

(11) **EP 2 770 544 A1**
(43) Date of publication of application: **27.08.2014**
(21) Application number: 13156170.6
(22) Date of filing: 21.02.2013
(51) Int. Cl.: H01L 31/18, H01L 21/268, H01L 31/0224

(54) **Method for forming metal silicide layers**

(71) Applicant: Excico Group, 3500 Hasselt (BE)
(72) Inventor: Emeraud, Thierry, 3500 Hasselt (BE); Lerat, Jean-François, 3500 Hasselt (BE)
(74) Representative: BiiP cvba

(57) **Abstract**

The present invention is directed to a method for forming a metal silicide layer on a non-textured silicon substrate surface, the method comprising:
- providing a metal layer on a non-textured silicon substrate,
- subsequently performing a pulsed laser annealing step providing at least one laser pulse, thereby converting at least part of the metal layer into a metal silicide layer.

In the addition, the present invention is directed to the use of such method in back side metallization of a photovoltaic cell.

## Description

### FIELD OF THE INVENTION

The disclosed technology relates to a method of forming metal silicide layers, and more in particular, a method of forming patterned metal silicide layers in a metallization process for silicon photovoltaic cells.

### BACKGROUND

The current industrial standard processes for front or back side metallization of silicon photovoltaic cells are based on printing of respectively silver or aluminum pastes or inks that need to be fired for good contact formation.

Due to their improved contact properties compared to silver paste, nickel silicide layers are used for forming front side contacts and can be formed by providing a thin nickel layer (e.g. by Physical Vapor Deposition (PVD), electroless plating, or Light Induced Plating (LIP)) on a silicon surface, followed by an annealing or sintering step to induce silicidation, resulting in the formation of a nickel-silicon alloy (nickel silicide). The annealing step is typically done in an inert environment (e.g. N₂) by rapid thermal annealing (RTA) or in a belt firing furnace.

A patterned nickel silicide layer is typically formed at the front side of the cells in openings created in an antireflection coating. On top of the nickel silicide layer at least one additional metal layer (such as a Cu layer) is typically electroplated (using the nickel silicide layer as a seed layer) to form low resistance contact paths.

An example of the above is illustrated in US2009223549 (Calisolar), describing a method which comprises forming openings in an anti-reflective coating, then coating the openings with a low contact resistance metal layer, in particular an electroless selective nickel layer, followed by rapid thermal annealing (RTA) at a process temperature generally below 400°C, to form metal silicide, in a particular nickel silicide.

A main problem of state-of-the art processes is the high risk for junction damage due to nickel diffusion into the silicon during the RTA silicidation process, resulting in shunting or junction damages.

An additional problem of conventional methods is that, because in an industrial fabrication process, the openings in the antireflection coating are typically formed by laser ablation, defects or damage to the silicon surface created by such laser ablation enhance the risk of nickel diffusion during a subsequent RTA silicidation process and thus an increased risk of (emitter) junction damage and (emitter) shunting.

Another main problem is that temperature non-uniformity of the RTA process can lead to non-uniformity in metal silicide thickness and composition and consequently to non-uniformity in contact resistance within cell and/or from cell to cell.

It is to be noticed that the problems listed above occur not only in case of front side contacts, but also in case of back side contacts. Particularly for the latter case, conventional methods nowhere provide a sufficient solution enabling metallization making use of metal silicide.

Considering the above, it is an object of the present invention to provide a method enabling more accurate control of metal diffusion into silicon, thereby decreasing the risk for junction damage and shunting.

Another object of the present invention is to provide a method enabling localized diffusion of metal into the silicon.

Another object of the present invention is to provide a method providing as an additional benefit the curing of defects generated by the laser ablation step.

Further, it is an object of the present invention to provide a method wherein the extent of diffusion of metal is less dependent on defects and damages in the silicon, but more dependent on thermal budget.

In addition, it is an object of the present invention to provide a method enabling formation of a metal silicide with improved roughness characteristics, i.e. the formed metal silicide may be more homogeneous, having a smoother interface and less spiking defects.

Further, it is also an object of the present invention to provide a method enabling improved metal silicide thickness uniformity and consequently improved contact resistance uniformity within cell and/or from cell to cell.

Further, it is also an object of the present invention to provide a method enabling better control of the metal silicide composition, in particular formation of metal mono-silicide.

In addition, it is also an object of the present invention to provide a method enabling formation of sufficient quality metal silicide not only for front side metallization, but also for back side metallization of a photovoltaic cell.

Finally, it is a main object of the present invention to provide a method for manufacturing photovoltaic cell with improved Fill Factor (FF), improved Pseudo Fill Factor (pFF), and improved overall performance compared to state of the art manufacturing methods.

The above objects are met by combining providing a metal layer on a non-textured silicon substrate and pulsed laser annealing.

### SUMMARY OF THE INVENTION

The present invention is directed to a method for forming a metal silicide layer on a non-textured silicon substrate surface, the method comprising:
- providing a metal layer on a non-textured silicon substrate,
- subsequently performing a pulsed laser annealing step providing at least one laser pulse, thereby converting at least part of the metal layer into a metal silicide layer.

In the addition, the present invention is directed to the use of such method in back side metallization of a photovoltaic cell.

### DETAILED DESCRIPTION

As a first embodiment in accordance with the present invention, a method for forming a metal silicide layer on a non-textured silicon substrate surface is provided, the method comprising:
- providing a metal layer on a non-textured silicon substrate,
- subsequently performing a pulsed laser annealing step providing at least one laser pulse, thereby converting at least part of the metal layer into a metal silicide layer.

In the context of the present invention, a non-textured silicon surface is understood as a silicon surface which is not particularly treated for achieving a higher degree of surface roughness, or higher degree of texturization. Typical treatment is wet or dry etch in either basic or acidic solution, or laser texturization or another method like nano-imprint or the like.

By combining providing a metal layer on a non-textured silicon substrate and subsequently performing a pulsed laser annealing step, the present invention allows formation of metal silicide on non-textured front side parts of a photovoltaic cell, as well as on the non-textured back side. For example, Metal-Wrap-Through cells and Back-Contact cells require contact formation on non-textured silicon.

The silicon may be for example crystalline silicon, undoped silicon or doped silicon, polycrystalline silicon, implanted silicon, or amorphous silicon.

It is a first advantage of the present invention that the risk of emitter junction shunting is avoided or substantially reduced as compared to prior art methods, even on a surface damaged by the patterning of the dielectric (such as laser ablation) or other previous process steps.

It is an advantage of the present invention that surface damage due to laser ablation may be cured.

It is an advantage of the present invention that a better metal silicide thickness control over the photovoltaic cells may be achieved.

It is an advantage of the present invention that controlled formation of mono-nickel silicide is enabled by means of a single shot annealing.

It is an advantage of the present invention that the duration of the laser pulses is very short, leading to reduced oxidation effects, such that working in ambient air becomes possible and the state of the art requirement to work in an inert environment is thereby avoided.

It is an advantage of the present invention, e.g. when used for the formation of front side contacts of a photovoltaic cell, that the substrate is only heated at the front side, thus for example enabling the use of temperature-sensitive surface passivation layers such as amorphous silicon or AlOₓ at the opposite side of the cell.

It is an advantage of the present invention that it can be performed with high throughput, e.g. in an industrial environment.

In an embodiment in accordance with the present invention, the metal is nickel and the metal silicide layer is a nickel silicide layer.

The laser source providing the at least one laser pulse may be any laser source whose wavelength, energy and pulse duration is adapted to the process, such as solid state lasers, diode lasers, or excimer lasers. Preferably, the laser source may be an excimer layer, more preferably a xenon chloride excimer laser.

The wavelength of the laser source may be in the range of 100 nm to 900 nm, 190 nm to 600 nm, 190 nm to 550 nm, or preferably 190 nm to 480 nm due to the high energy absorption of silicon at those wavelengths.

The irradiation energy may be in the range of 1 Joules to 25 Joules. In order to achieve these energies, the laser discharge volume is optimized to typically 10 cm (inter electrodes spacing) x 7 to 10 cm (discharge width) x 100 to 200 cm (discharge length).

In an embodiment in accordance with the present invention, the pulse duration may be in the range between about 1 ns and 10 ms, for example between about 1 ns and 1 ms, preferably between 1 ns and 250 ns,

In an embodiment in accordance with the present invention, a single laser pulse is used, with a pulse duration in the range between about 1 ns and 10 ms, for example between about 1 ns and 1 ms, particularly between about 1 ns and 250 ns.

Without being bound by any theory, using single shot excimer laser annealing at appropriate energy density value with appropriate pulse length may generate a melt of silicon substrate under a metal layer, and create a metal silicide in the melted region only.

In an embodiment in accordance with the present invention, providing the metal layer can be done by any suitable metal deposition method known to a person skilled in the art, such as for example PVD, electroless plating, electroplating, light induced electroless plating (LIEP), or even more preferably light induced plating (LIP). Preferably a selective plating process, such as LIP, is used. The combination of a selective plating process and pulsed laser annealing may result in less debris and in even better metal silicide thickness control.

The thickness of the metal layer can be in the range between about 1 nm and 2000 nm, particularly between about 10 nm and 200 nm, more particularly between about 20 nm and 100 nm, preferably between about 20 nm and 50 nm, and even more preferably between 40 nm and 50 nm.

In an embodiment in accordance with the present invention, the laser energy density is between 0.1 J/cm2 and 1.5 J/cm2, preferably between 0.3 J/cm2 and 1.0 J/cm2, even more preferably between 0.3 J/cm2 and 0.7 J/cm2.

Preferably a single laser pulse is used having a relatively large beam spot size, e.g. substantially larger than a width of the openings in the dielectric layer, thereby avoiding the need for alignment of the laser beam to the openings. A step-and-scan approach can be used for irradiating the whole substrate surface. Preferably the beam spot size matches or is larger than the whole substrate surface.

The laser beam spot form may be square or rectangular. For a square-shaped shot, its size may be in the range between about 2 mm x 2 mm and 10 cm x 10 cm, such as about 1 cm x 1 cm. For a rectangular-shaped spot, its length may be equal to the one of the solar cells or slightly superior or inferior, e.g. 125mm, 156mm or even 200mm, and its width may be in the range between about 0.1 and 50mm. Using narrow elongated rectangular shapes, the laser irradiation may comprise scanning the substrate surface in the perpendicular direction to the spot line, which makes the present invention suitable for industrial manufacturing at high throughputs.

A step-and-scan approach can be used for irradiating the entire substrate surface. For example, a system as described in WO 2010/115763 can be used for performing the laser annealing step at high throughput.

In a particular embodiment in accordance with the present invention, with each pulse a portion of at least 1 cm², at least 5 cm², at least 10 cm², or at least 100 cm² may be irradiated, which makes the present invention suitable for industrial manufacturing of photovoltaic cells at high throughputs.

In an embodiment in accordance with the present invention, a method for forming a patterned metal silicide layer on a silicon substrate comprises: providing a dielectric layer on the silicon substrate; forming openings through the dielectric layer at locations where a metal silicide layer needs to be formed; providing a first metal layer on the substrate by PVD or plating, at least at the location of the openings; and performing a pulsed laser annealing step at least at the location of the openings with a laser energy density in the range between about 0.1 J/cm² and 1.5 J/cm², particularly between about 0.3 J/cm² and 1.0 J/cm², thereby converting at least part of the metal layer into a metal silicide layer.

In an embodiment in accordance with the present invention, the dielectric layer provided on the silicon substrate can be a single dielectric layer, such as a SiNₓ, SiO₂ or AlOₓ layer, or a stack comprising at least two dielectric layers, such as a SiO₂/SiNₓ stack or an AlOₓ/SiNₓ stack. In a photovoltaic cell, the dielectric layer or dielectric layer stack can provide surface passivation and/or can function as an antireflection coating.

In an embodiment in accordance with the present invention, the dielectric layer is patterned onto the silicon substrate such that the metal layer is locally in contact with silicon. Patterning the dielectric layer can for example be done by laser ablation. However, the present disclosure is not limited thereto and other suitable methods can be used. For example, forming openings through the dielectric layer can comprise providing a patterned masking layer (such as by inkjet printing) followed by wet etching of the dielectric layer.

After performing the laser annealing step, an etch step is performed for removing unreacted metal in case the metal layer was not selectively deposited. The etch step can for example comprise etching in a wet etching solution comprising HNO₃, H₂O₂:H2_{S}O₄ or HCl:HNO₃ or any other suitable etching solution known by a person skilled in the art. This etch step is followed by a (second) plating step, preferably electroplating, light induced plating, or light induced electroless plating thereby e.g. forming a Ni/Cu stack or a Ni/Cu/Ag stack or a Ni/Cu/Sn stack or any other suitable stack known to a person skilled in the art on top of the metal silicide layer.

As understood by person skilled in the art, a method in accordance with the present invention may be used for providing contacts to the front side of a photovoltaic cell and can also be used for providing contacts to the rear side of a photovoltaic cell.

The method can be used in a fabrication process for different types of photovoltaic cells, such as Back Contact cells, Metal Wrap Through cells, Emitter Wrap Through cells, Back Junction cells, Interdigitated Back Contact cells, and bifacial cells.

The example below describes an embodiment wherein the metal is nickel and wherein the metal silicide layer is a nickel silicide layer. However, the present disclosure is not limited thereto. Other metals can be used such as Co, Ti, TiW or Pt and other metal silicides can be formed.

### EXAMPLE

In below example, a patterned nickel silicide layer is provided as part of the contacting process of a crystalline silicon solar cell and can be referred to all crystalline silicon solar cells with a patterned contact on a non-textured surface as can be found on the solar cell back side of e.g. Metal-Wrap-Through cells and Back-Contact cells.

Interdigitated Back-Contact (IBC) solar cell features patterned doped silicon (crystalline or amorphous) regions at the non-textured rear side. These doped regions with opposite electrical charge are separated by a gap to avoid parasitic shunt. The gap is filled with an insulating layer being a dielectric layer, chosen for its electrical passivation properties on silicon surfaces. The dielectric layer or dielectric stack can for example comprise a silicon oxide or silicon nitride layer or a combination of both.

Subsequently, a nickel layer is deposited upon this structure, either over the whole rear surface (by PVD for instance), or only locally upon one or several silicon patterns (e.g. by LIP). In these ways, silicon is only locally exposed to a metal at locations where a nickel silicide contact layer needs to be formed in a later phase of the process.

In preferred embodiments the thickness of the nickel layer is in the range between 20 nm and 200 nm. However, the present disclosure is not limited thereto, and thinner or thicker nickel layers can be used.

After providing the nickel layer a pulsed laser annealing step using an excimer laser is done thereby converting at least part of the nickel layer at locations where the nickel layer is in contact with the silicon into a nickel silicide layer.

Preferably, a XeCl Excimer laser with 308 nm wavelength generating a single 150 ns laser pulse between 0.3 J/cm2 and 1.0 J/cm2 is used for irradiating the nickel layer and inducing silicidation.

Then this step can be followed by the removal of the non-reacted nickel layer on silicon areas or over the dielectric layers or any protective layers on any part of the cell. A second plating step, using the nickel silicide layer as a seed layer can be realized to form for example a Ni/Cu/Ag stack. These silicide seed layers also enabling a better mechanical adhesion of the stack on silicon.

Simulations show that the preferred laser energy density can be influenced by the thickness of the nickel layer, because the thickness of the nickel layer has an effect on the reflectivity of the irradiated surface. For example, for a nickel layer thickness of 20 nm a laser energy density up to 1 J/cm² may be used. For a nickel layer thickness in the range between 50 nm and 100 nm the surface reflectivity is reduced (as compared to the case of a 20 nm thick nickel layer), and preferably a lower laser energy density is used, e.g. in the order of 0.5 J/cm².

For thicker nickel layers, such as in the range between 500 nm and 2000 nm higher laser energy densities are needed because more heat is absorbed in the nickel layer. However, these higher laser energy densities are preferably avoided because they may damage the surface passivation quality of the dielectric layer.

Damage to the passivation quality of the dielectric layer may be avoided by performing the laser annealing step at a laser energy density lower than 1.0 J/cm².

It is observed that XeCl laser annealing at 0.55 J/cm² results in an open-circuit-voltage V_{oc} and a short-circuit density J_{sc} in the same order or better than the one of the V_{oc} and J_{sc} obtained with standard RTA anneal.

Further, it is observed that XeCl laser annealing at 0.55 J/cm² leads to a reduced diode damage (higher FF and pFF) as compared to standard RTA annealing. This is related to rapid diffusion of nickel by RTA through defects created during laser ablation of the antireflection coating, leading to spiking of the junctions.

It is also observed that in the resulting NiSi, using laser energy densities between 0.3 J/cm2 and 1.0 J/cm2, the mono NiSi phase is generally present, whereas for higher laser energy densities a relative higher presence of the NiSi₂ phase is observed. Mono NiSi phase achieves the lowest contact resistance value on silicon, thereby increasing cell fill factor.

It is also observed that the combination of plating, in particular LIP, and laser annealing results in formation of a metal silicide with improved roughness characteristics (smoother NiSi layer) and in improved metal silicide thickness uniformity and consequently improved contact resistance uniformity within cell and/or from cell to cell compared to state of the art methods.

## Claims

1. A method for forming a metal silicide layer on a non-textured silicon substrate surface, the method comprising:
- providing a metal layer on a non-textured silicon substrate,
- subsequently performing a pulsed laser annealing step providing at least one laser pulse, thereby converting at least part of the metal layer into a metal silicide layer.

2. A method according to claim 1, wherein the laser energy density is in the range between 0.1 J/cm2 and 1.5 J/cm2.

3. A method according to claims 1 or 2, wherein the laser pulse duration is between 1 ns and 10 ms.

4. A method according to claims 1 to 3, wherein the laser pulse is provided by an excimer laser.

5. A method according to claim 4, wherein the laser pulse has a wavelength of 308 nm.

6. A method according to any of the above claims, wherein the laser annealing is performed in ambient air.

7. A method according to any of the above claims, wherein the thickness of the metal layer is in the range between 20 nm and 200 nm.

8. A method according to any of the above claims, wherein the metal layer is provided by PVD or by a plating process.

9. A method according to claim 8, wherein the metal layer is provided by Light Induced Plating or light induced electroless plating.

10. A method according to any of the above claims, further comprising:
- providing a dielectric layer on the non-textured surface of the silicon substrate, the dielectric being open at predetermined locations where the patterned metal silicide layer needs to be formed.

11. A method according to claim 9 wherein the metal layer is at least provided at the location of the predetermined openings.

12. A method according to claims 9 or 10, wherein forming openings through the dielectric layer comprises forming the openings by means of laser ablation.

13. A method according to any of the previous claims, further comprising performing a second plating step, thereby forming a second metal layer on top of the metal silicide layer.

14. A method according to claim 12, wherein the second plating process is electroplating, light induced plating or light induced electroless plating.

15. Use of a method according to any of the previous claims in back side metallization of a photovoltaic cell.
